(19) **Europäisches Patentamt**

**European Patent Office**

**Office européen des brevets**

(11) Veröffentlichungsnummer : **0 135 210**
**B1**

(12) **EUROPÄISCHE PATENTSCHRIFT**

(45) Veröffentlichungstag der Patentschrift :
11.11.87

(51) Int. Cl.⁴ : **H 05 K   9/00**, H 05 K   5/04

(21) Anmeldenummer : **84201008.4**

(22) Anmeldetag : **11.07.84**

(54) Metallisches, aus aufgefaltetem Blech gebildetes Abschirmgehäuse.

(30) Priorität : 14.07.83 DE 3325360

(43) Veröffentlichungstag der Anmeldung :
27.03.85 Patentblatt 85/13

(45) Bekanntmachung des Hinweises auf die Patenterteilung : 11.11.87 Patentblatt 87/46

(84) Benannte Vertragsstaaten :
DE FR GB IT

(56) Entgegenhaltungen :
FR-A- 2 419 651
FR-A- 2 428 372
US-A- 1 963 951
US-A- 4 214 360
US-A- 4 386 388

(73) Patentinhaber : Philips Patentverwaltung GmbH
Wendenstrasse 35 Postfach 10 51 49
D-2000 Hamburg 1 (DE)
DE
N.V. Philips' Gloeilampenfabrieken
Groenewoudseweg 1
NL-5621 BA Eindhoven (NL)
FR GB IT

(72) Erfinder : Friese, Paul
Gatzenstrasse 164
D-4150 Krefeld 1 (DE)

(74) Vertreter : Kupfermann, Fritz-Joachim, Dipl.-Ing. et al
Philips Patentverwaltung GmbH Wendenstrasse 35
Postfach 10 51 49
D-2000 Hamburg 1 (DE)

## Beschreibung

Die Erfindung bezieht sich auf ein metallisches, aus aufgefaltetem Blech gebildetes Abschirmgehäuse zur allseitig abgeschirmten Aufnahme einer beschalteten Schaltungsplatine, bei dem der Boden und die Seitenwände durch das Auffalten eines einzigen Blechschnittes gebildet sind.

Solche Schaltungsplatinen können dabei in abzuschirmenden Kombibausteinen, wie beispielsweise Breitbandverstärker mit oder ohne Modulator, oder Abstimmvorrichtungen für elektrische Hochfrequenzaufnahme- und Wiedergabegeräte, die allgemein unter der Bezeichnung Tuner bekannt sind, zum Einsatz kommen. Die Gehäuse werden üblicherweise aus Weißblech, einem verzinnten Eisenblech, gefertigt. Boden und Seitenwände sind durch Auffalten eines Blechzuschnittes gebildet. Der zum Gehäuse gehörige Deckel wird aus einem getrennten Blechschnitt durch Auffalten und Verformen hergestellt. Der metallische Kontakt zwischen Deckel und Gehäuse wird über sogenannte Federn herbeigeführt, die aus dem Deckelblech geschnitten sind und längs der Seitenwände gegen diese drücken.

Blechzuschnitte für Gehäuse, die durch Auffalten ihre Bestimmungsform erhalten, sind beispielsweise aus den FR-PSen 2 419 651 und 2 428 372 bekannt. Aus diesen bekannten Zuschnitten werden Hauben oder deckellose Dosen gebildet, deren freie Kanten beispielsweise durch seitliches Umfalzen noch versteift sind. In der FR-PS-2 428 372 sind darüber hinaus Lochreihen vorgegeben, die eine Knickbildung begünstigen. Die Löcher sind oval gehalten und geben keine definierte Knicklinie vor. Wo Toleranzen berücksichtigt werden müssen und deshalb exakt gefalzt werden muß, reicht eine derartige Lochformung nicht.

Es ist Aufgabe der Erfindung, ein Gehäuse für eine Abstimmvorrichtung zu schaffen, das zeit- und maschinensparend herstellbar ist und bei dem die Deckelkontaktierung verbessert ist.

Die gestellte Aufgabe ist erfindungsgemäß dadurch gelöst, daß auch der Deckel Bestandteil des Blechzuschnittes ist und mit einer Seitenwand durchgehend metallisch durchverbunden bleibt, jedoch längs einer von Knickdurchbrüchen gebildeten Knicklinie schwenkbar an der Seitenwand gehalten ist, wobei die Ränder der Knickdurchbrüche von einer Stanzkante längs der Knicklinie und einer die Enden der Stanzkanten verbindenden, wenigstens im Bereich der Enden gekrümmten Bogenkante gebildet sind.

Der Deckel braucht also nicht als getrenntes Bauteil gefertigt, gelagert und montiert zu werden ; er ist einstückiges Bestandteil des Gehäuses und wird bei der Endmontage einfach umgelegt. Ein weiterer Vorteil ist die außerordentlich störstrahlungssichere Kontaktierung zwischen Gehäuse und Deckel.

Durch die längs der Knicklinie verlaufende Stanzkante und die bogenförmige Ausformung der anderen Durchbruchkante wird sichergestellt, daß der Deckel genau längs der Knicklinie auf die Gehäusewände zu gebogen werden kann.

Das Gehäuse nach der Erfindung dient insbesondere als Umgehäuse für einen einzubringenden elektronischen Funktionsteil. Dieser besteht aus einer Schaltungsplatine und Abschirmrahmen, die die Platinenaußenabmessungen umgeben. Die Schaltungsplatine ist mit diesen Rahmen verlötet und bildet mit diesen Rahmen eine funktionsfähige Abstimmvorrichtung, die oben und unten offen ist und dadurch leicht abgeglichen werden kann. Diese Abstimmvorrichtung mit ihren umlaufenden Rahmen oder Schottwänden muß mit dem aus dem Blechzuschnitt gebildeten Gehäuse verbunden werden. Dazu ist nach einer weiteren Ausgestaltung der Erfindung vorgesehen, daß in den Gehäusewänden Lötdurchbrüche vorgesehen sind, hinter denen flächig die Schaltungsplatine einrahmende Schottwände zu liegen kommen, und daß diese Schottwände mit den Gehäusewänden im Bereich der Lötdurchbrüche verlötet sind. Die Schaltungsplatine mit den Rahmen oder Schottwänden braucht nicht exakt eingepaßt zu sein. Durch das Lot werden Toleranzen zwischen den Schottwänden und den Gehäusewänden ohne Schwierigkeiten ausgeglichen.

Antenneneingänge in Hochfrequenzabstimmvorrichtungen sind stets problematisch. Trotz aller Kunstgriffe, wie beispielsweise besonderer Kontaktfedergestaltung und besonderem Anpreßdruck zwischen Deckelfedern und Gehäuseseitenwänden bleibt die Abschirmung von aufgesetzten Deckeln ein Problem. Nach einer weiteren Ausgestaltung der Erfindung ist deshalb vorgesehen, daß der Antenneneingang durch die Seitenwand geführt ist, längs der sich der homogene Übergang vom Deckel zum Boden vollzieht. Auf diese Weise wird erstmalig eine exakte Vollkontaktierung herbeigeführt, die insbesondere darauf beruht, daß der Deckel nicht durch Federn aufgeklemmt, sondern metallisch mit dem Gehäuse durchverbunden ist. Durch den homogenen Blechübergang vom Deckel über die Seitenwand bis zum Boden im Bereich des Antenneneingange wird damit eine Abschirmung erreicht, die in ihrer Güte mit gefiederten Deckeln nicht denkbar ist.

Nach einer weiteren Ausgestaltung der Erfindung sind an wenigstens einer der Gehäusewände Fußlappen vorgesehen, auf denen die Vorrichtung hochkant oder liegend sicher abgestützt werden kann. Es ist auch möglich, aus dem Deckel als Füße dienende Stützlappen auszubiegen.

Es gibt Bauteile bei Abstimmvorrichtungen, die auch bei geschlossenem Gehäuse evtl. noch nachabgeglichen werden müssen. Um diesen Nachabgleich, ohne das Gehäuse noch einmal mechanisch öffnen oder schließen zu müssen, möglich zu machen, ist nach einer weiteren Ausgestaltung der Erfindung vorgesehen, daß in dem Boden Fenster vorgesehen sind, durch die die Seite der Platine mit den abgleichbaren Bauteilen zugänglich bleibt, und daß die Fenster mittels einer metallischen Abschirmfolie abdeckbar sind, die gleichzeitig als Typenschild ausgebildet ist. Das Gehäuse ist also blechmäßig vor der evtl. Nachabstimmung vollständig geschlossen. Die verbleibenden, der Nachabstimmung dienenden Löcher werden dann erst, wenn die Abstimmvorrichtung zur Ablieferung fertig ist, mit Hilfe der vorzugsweise selbstklebend aufgebrachten metallischen Abschirmfolie verschlossen, wobei dieser letzte Abschirmverschluß gleichzeitig das Typenschild ist. Die Abschirmfolie und das Typenschild sind also ein Bestandteil des Gehäuses.

Die Erfindung wird anhand des in den Zeichnungen dargestellten Ausführungsbeispieles näher erläutert. Es zeigen :

Fig. 1 schaubildlich eine Explosionsansicht der Teile eines funktionsfähigen Zwischenbausteine einer Abstimmvorrichtung, wobei die Tauchseite oben dargestellt ist,

Fig. 2 schaubildlich die zusammengesetzte Abstimmvorrichtung nach Fig. 1,

Fig. 3 den aus einem Stück bestehenden Blechzuschnitt des Gehäuses,

Fig. 4 und 5 Darstellungen des Gehäuses, in das der Zwischenbaustein nach den Fig. 1 bis 3 eingelötet wird,

Fig. 6 eine als metallische Abschlußwand und als Typenschild dienende Aufklebfolie,

Fig. 7 eine Draufsicht auf den Zwischenbaustein nach Fig. 2 mit einer neuen Auskopplungsanordnung,

Fig. 8 und 9 den Aufbau einer kompakten Drei-Ebenen-Bauelementeanordnung auf einer Schaltungsplatine,

Fig. 10 eine vergrößerte Darstellung eines Schnittes X-X durch einen Rand des Zwischenbausteines vor dem Verlöten.

Im Rahmen immer kleiner werdender Peripheriegruppen an Hochfrequenzgeräten, wie beispielsweise Fernsehgeräten oder Videogeräten, ist es notwendig, die einzelnen Peripheriebaugruppen, wie auch die Abstimmvorrichtungen, in ihren Abmessungen kleiner auszulegen und dabei durch die Anwendung von automatisierbaren Arbeitsvorgängen die Herstellungskosten zu vermindern. Eine solche Abstimmvorrichtung soll beispielsweise auf die Abmessungen von etwa 51 × 34 × 12 begrenzt sein. In herkömmlicher Bautechnik ist bei einer derartigen Miniaturisierung Aufbau und Abgleich schwierig.

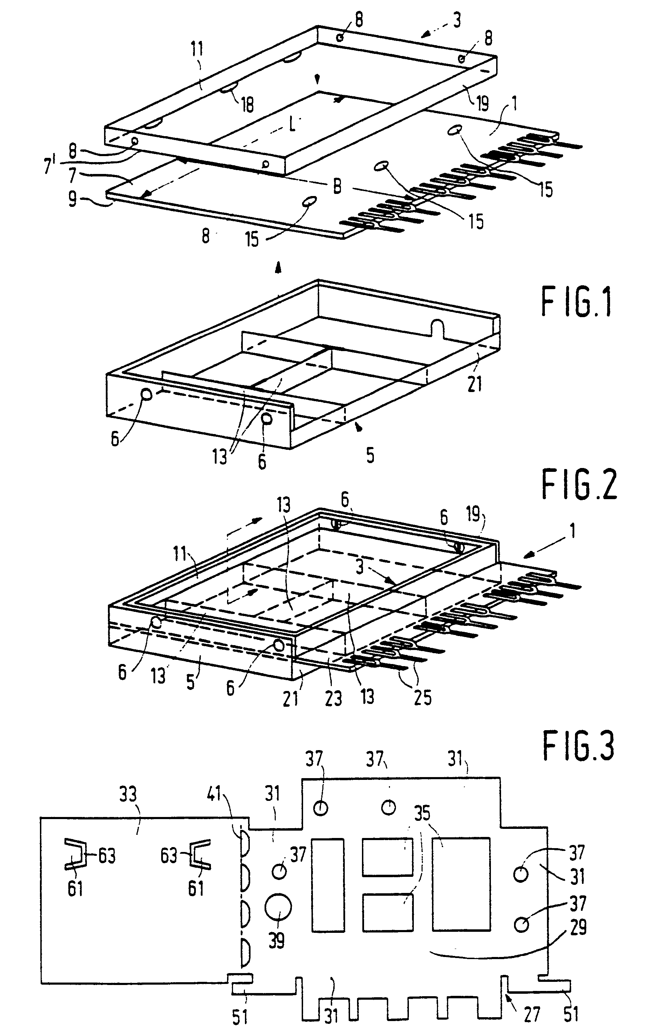

Fig. 1 zeigt in schaubildlicher Darstellung einen Zwischenbaustein, mit dem es möglich ist, schwankende Abmessungstoleranzen eines Dickschichtsubstrates 1 zuzulassen. Das Dickschichtsubstrat hat beispielsweise eine Längenabmessung L von ca. 50 mm und eine Breitenabmessung b von ca. 33 mm.

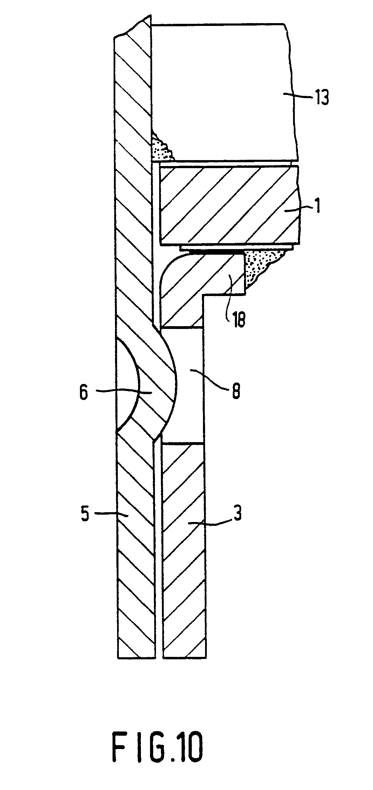

Zu dem Zwischenbaustein gehören zwei Schottrahmen 3 und 5, die flächig von der Tauchseite 7 und von der ungetauchten Seite 9 mit ebenen Kanten 8, die frei von Schwertern sind, auf das Dickschichtsubstrat auflötbar sind. Vor dem Auflöten sind Substrat 1 und Schottrahmen 3, 5 wegen der ebenen Auflage und wegen der Vermeidung der sonst üblichen Schwerter schwimmend gegeneinander verschieblich, so daß Toleranzen bequem ausgleichbar sind. Wie sich deutlich aus Fig. 2 und 10 ergibt, ist der Schottrahmen 3 ein wenig kleiner als der Schottrahmen 5. Dadurch fällt der Schottrahmen 3 beim Zusammenlegen der Teile bis auf das Substrat 1 in den Schottrahmen 5 hinein, wobei dann die äußeren Ränder in einer Ebene liegen.

Die schwimmende, Toleranzen überwindende Anbringung wird noch dadurch verbessert, daß Schottrahmen außerhalb von drei Seitenrändern der Schaltungsplatte angeordnet sind und sich vor diesen Seitenrändern überlappen und daß die Rahmen im Bereich der Überlappungen vor dem Verlöten mittels Einschnappverbindungen gegenseitig verrastet sind. Die Ränder der Schaltungsplatte liegen also immer frei, so daß die Plattenabmessungen schwanken können. Fig. 10 zeigt anhand einer vorgrößerten Schnittdarstellung, wie die sich überlappenden Schottrahmen 3, 5 das Dickschichtsubstrat 1 zwischen sich schwimmend festklemmen und wie der Schottrahmen 5 mit einer Sicke 6 in ein Loch 8 des Schottrahmens 3 eingreift, wodurch die Schnappverbindung zustande kommt.

Auf dem Dickschichtsubstrat 1 befinden sich nicht dargestellte flächenhafte Leitungszüge, zu denen auch Leitungszüge zählen, die auf Null oder Erdungspotential liegen. Diese Leitungszüge sind teilweise bewußt so gelegt, daß sie Auflötflächen bilden, mit denen die Schottwände 11 des Schottrahmens 3 und die Schottwände 13 des Schottrahmens 5 verlötbar sind. Dort, wo derartige Lötflächen aufgrund der Schaltung nicht bereit stehen, sind besondere Einzellötflächen 15 vorgesehen, mit denen die Schottrahmen 3 und 5 und das Substrat 1 verlötbar sind. Am Schottrahmen 3 können abgebogene Lappen 18 vorgesehen werden, die verbreiterte Lötflächen bilden. Die außen umlaufenden Schottwände der Schottrahmen 3 und 5 erstrecken sich je nach den Toleranzen des Dickschichtsubstrates genau oder ungefähr genau längs der Ränder des Substrates 1. Zwei Schottwände 19 und 21 der Rahmen 3 und 5 machen jedoch eine Ausnahme. Diese Schottwände 19 und 21 lassen zwischen sich einen Streifen 23 des Dickschichtsubstrates 1 aus dem Hochfrequenzraum heraustreten. An diesen Streifen 23 des Substrates sind Anschlußstifte 25 angeschlagen.

Ist das Dickschichtsubstrat 1 auf später noch zu beschreibende Weise vollständig bestückt, dann werden die Schottrahmen 3 und 5 von beiden Seiten 7 und 9 auf das Substrat 1 aufgelötet, wobei dieser Lötvorgang zusammen mit dem Anlöten der übrigen Bestückungsteile erfolgt. Dabei entsteht ein voll funktionsfähiger Zwischenbaustein, der auch ohne Gehäuse und ohne abschließende Deckel voll funktionsfähig ist. Dieser Zwischenbaustein läßt sich gut abgleichen, da alle seine Bauteile für Abgleiche und Fehlerkontrollen freiliegen.

Fig. 3 zeigt die Abwicklung des Gehäuses, in das der Zwischenbaustein nach den Fig. 1 und 2 einsetzbar ist. Die Abwicklung besteht aus einem einzigen Blechzuschnitt, beispielsweise aus Weißblech. An diesem Blechzuschnitt 27 befinden sich der spätere Boden 29, die Gehäusewände 31 und der Gehäusedeckel 33. Im Boden 29 sind Fenster 35 vorgesehen. Die Seitenwände 31 weisen Lötdurchbrüche 37 auf, und eine der Seitenwände hat ein Antennenloch 39.

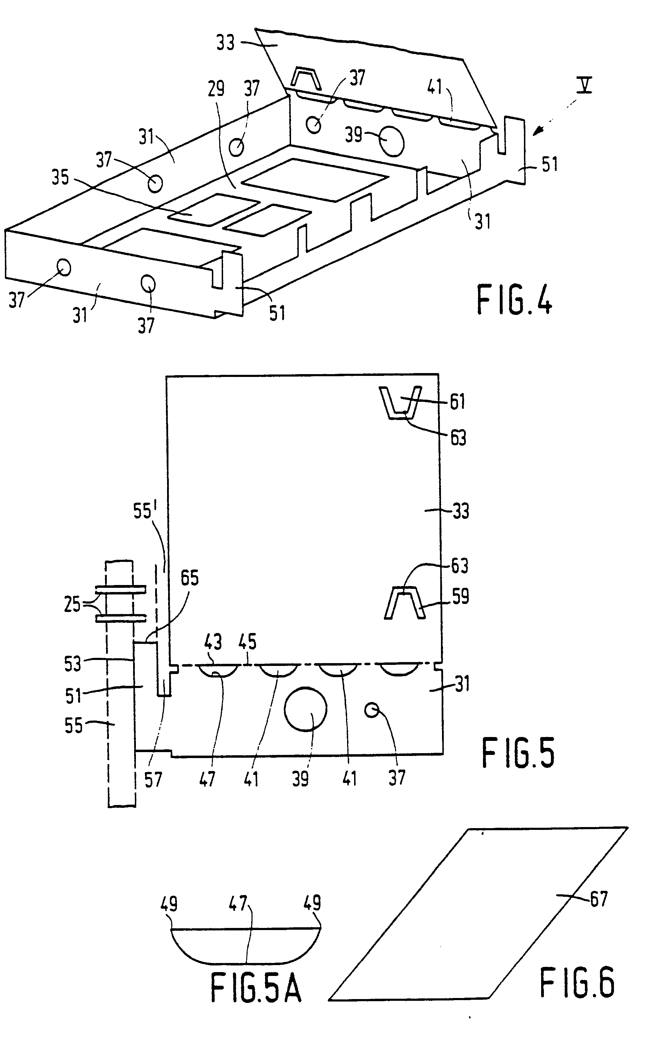

Fig. 4 zeigt nun in schaubildlicher Darstellung, wie der Blechzuschnitt 27 nach Fig. 3 durch Auffalten zu einem Gehäuse wird. Am Boden 29 erkennt man die Fenster 35. In den Seitenwänden 31 befinden sich die Lötdurchbrüche 37, und der Gehäusedeckel 33 ist über Knickdurchbrüche 41 an der Gehäusewand 31 mit dem Antennendurchbruch 39 fest, jedoch abknickbar verbunden.

In Fig. 5 ist in Richtung eines Ansichtspfeiles 5 eine Ansicht des Gehäuses dargestellt, aus der besonders deutlich zu erkennen ist, wie der Gehäusedeckel 33 mit einer der Seitenwände 31 homogen verbunden ist und bleibt. Durch die Seitenwand 31 ist der Antenneneingang hindurchgeführt. Der homogene Blechübergang von Deckel über Seitenwand 31 zum Boden sorgt für eine besondes gute Freiheit von HF-Störeffekten. Die Knickdurchbrüche 41 bestehen jeweils aus einer geradlinigen Stanzkante 43, die in die Knicklinie 45 fällt. Die andere Kante des Durchbruches 41, die Bogenkante 47, ist vornehmlich im Bereich der Enden 49 der Stanzkante 43 gebogen.

An das Gehäuse sind Fußlappen 51 angeschnitten. Diese Fußlappen 51 ermöglichen es, die Abstimmvorrichtung mit einer Vorderkante 53 vertikal auf einer gestrichelt angedeuteten Schaltungsplatte 55 hochkant aufzustellen. Die Anschlußstifte 25 können dann in diese Schaltungsplatte 55 eingelötet sein. Ebenso ist es möglich, die Abstimmvorrichtung beispielsweise in eine andere Schaltungsplatte 55' einzustecken, wobei diese Schaltungsplatte 55' in vorgesehene Nuten 57 zwischen Fußlappen und Gehäusewand 31 eindringt.

Ist der Deckel 33 auf das Gehäuse aufgeschwenkt und werden durch U-förmige Ausstanzungen 59 gebildete Stützlappen 61 ausgebogen, dann kann die Abstimmvorrichtung auf den Vorderkanten 63 der Stützlappen 61 und den Vorderflächen 65 der Fußlappen 51 im Abstand von einer Schaltungsplatte auf diese aufgelötet werden.

Ist die Abstimmvorrichtung vollständig fertig abgestimmt und betriebsbereit, dann wird auf die Fenster 35 eine Metallfolie 67 aufgeklebt, die die Fenster 35 verschließt und gleichzeitig als Typenschild ausgebildet sein kann. Das restlose Verschließen der Abstimmvorrichtung und die Aufbringung eines Typenschildes lassen sich auf diese Weise sinnvoll miteinander verbinden.

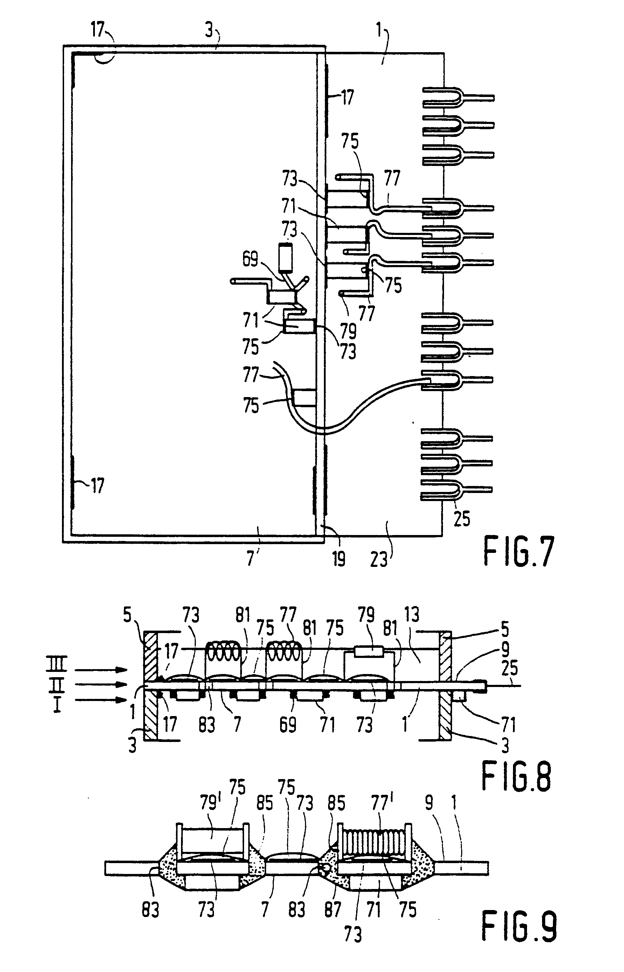

Die Fig. 7 bis 9 zeigen nun verschiedene Schaltungstechniken, mit denen es möglich ist, in möglichst gedrängter Bauweise mit einfachen Bauteilen und möglichst vollautomatisch die Schaltung des Tuners anzubringen. Das Dickschichtsubstrat 1 wird in Fig. 7 von seiner Tauchseite 7 her flächig gezeigt. Auf das Dickschichtsubstrat ist der Metallrahmen 3 aufgelötet. Lötflächen 17 sind schematisch angedeutet. Auf der Tauchseite des Substrates befinden sich im Sinterverfahren aufgebrachte Leiterbahnen 69. Die Leiterbahnen verbinden einzelne Bauteile, wie auf der Tauchseite liegende Chipschichtkondensatoren 71. Das Leitungsbild ist nicht im einzelnen aufgezeichnet, weil es für die Erklärung keine Bedeutung hat.

An den über die Schottwand 19 aus dem Hochfrequenzteil herausragenden Streifen 23 des Dickschichtsubstrats sind die Anschlußstifte 25 angeschlagen. Bei vier dieser Anschlußstifte ist dargestellt, wie die Hochfrequenzenergie aus dem Hochfrequenzraum durch die Chipschichtkondensatoren im Bereich der Streifen 25 praktisch kurzgeschlossen wird, womit zu den Anschlußstiften 25 nur Nutzsignale gelangen. Zur Auskopplung dienen Chipschichtkondensatoren 71 und die Schottwand 19. Diese Chipschichtkondensatoren 71 sind zunächst auf das Substrat 1 im üblichen Bestückungsverfahren aufgeklebt. Jeder der Chipschichtkondensatoren 71 hat zwei Kontaktflächen 73, 75. Die eine Kontaktfläche 73 ist jeweils mit der geerdeten HF-abschirmenden Schottwand 19 entweder außerhalb oder innerhalb der Schottwand 19 verlötet. Längs der anderen Kontaktfläche 75 verläuft jeweils ein auszukoppelnder Leiter 77. Um eine gute hochfrequenzmäßige Trennung herbeizuführen, verlaufen die Leiter 75 möglichst über die ganze Kontaktfläche 75 der Chipschichtkondensatoren 71 hinweg und sind durch Anlöten gut kontaktiert. Auch die Leiter 77 sind als flächenhafte Leitungszüge ausgebildet. Entweder sind sie isoliert zwischen der Schottwand 19 und der Oberfläche des Dickschichtsubstrates in den Hochfrequenzraum eingeführt oder aber durch Durchkontaktierungen auf die ungetauchte Seite 9 hindurchgezogen mittels sich durch Lotbrückendurchbrüche 83 erstreckender Lotbrücken 87 und dann auf der ungetauchten Seite in den Hochfrequenzraum eingeführt. Diese Hochfrequenzleiterauskopplungen entsprechen funktionsmäßig vollständig den üblichen Rohrdurchführungen, sind aber gegenüber diesen wesentlich wirtschaftlicher erstellbar.

Fig. 8 zeigt eine Drei-Ebenen-Anordnung von Bauteilen auf einem Dickschichtsubstrat 1, um so zu einer größeren Packungsdichte und einem vereinfachten Löten zu gelangen. Auf der Tauchseite 7 des Dickschichtsubstrates sind flächenhafte Leitungszüge 69 derart angeordnet, wie sie in Fig. 7 angedeutet sind. Die flächenhaften Leitungszüge erstrecken sich natürlich über die gesamte Tauchseite 7. Nach ihrem Aufkleben werden Chipschichtkondensatoren 71 mit den flächenhaften Leitungszügen 69 verlötet. Auf der Tauchseite 7 können auch integrierte Schaltungen angeordnet werden. In der Anordnungsebene, die in Fig. 8 mit I bezeichnet ist, ist es auf jeden Fall wichtig, daß nur beim Löten in das Lötbad tauchbare Bauelemente vorgesehen werden.

In einer Anordnungsebene II, die sich direkt auf der ungetauchten Seite 9 des Dickschichtsubstrates 1 befindet, sind wieder flächenhafte Leitungszüge im Sinterverfahren aufgetragen. Diese Leitungszüge verbinden teilweise Dickschichtwiderstände 73. Die Anordnungsebene II wird geschlossen mit Hilfe einer abdeckenden isolierenden Abdeckschicht 75. Nur in der dritten Anordnungsebene befinden sich konkrete, nicht tauchfähige Bauteile, wie Spulen 77, Lackwiderstände, Dioden und weitere integrierte Schaltungen 79. Diese Bauteile haben Anschlußbeine 81, die sich durch Lotbrückendurchbrüche 83 des Dickschichtsubstrates 1 hindurch zur Tauchseite 7 erstrecken. Auf dieser Tauchseite 7 sind die Anschlußbeine 81 mit den Leitungszügen 69 auf der Tauchseite 7 verlötbar.

Das Löten der Dickschichtsubstratplatte zusammen mit den Rahmen 3 und 5 erfolgt in einem einzigen Tauchlötvorgang, ohne daß das Dickschichtsubstrat gewendet werden muß. Dies führt verfahrensmäßig zu wesentlichen Einsparungen. Das Dickschichtsubstrat wird mit seiner Tauchseite 7 in das Tauchlötbad eingetaucht. Dabei verlöten auf der Tauchseite die Kontaktflächen der Chipschichtkondensatoren 71 mit den flächenhaften Leitungszügen 69. Auch verlöten selbstverständlich eingesetzte Anschlußbeine von integrierten Schaltungen mit den flächenhaften Leitungszügen. Das Dickschichtsubstrat wird so tief getaucht, daß das Lot durch die Lotdurchbrüche 83 hindurchdringt bis auf die nicht-getauchte Oberfläche 9. Auf dieser Oberfläche können dann die von der Abdeckungsschicht 75 freien Teile der Lötflächen 17 mit den Rahmen 5 und 3 verlöten. Zum gesamten Löten ist mithin nur ein Tauchvorgang erforderlich, um alle Lötvorgänge auf beiden Seiten durchzuführen.

Fig. 9 zeigt eine Abwandlung von konkreten Bauelementen 77' und 79'. Auf der Tauchseite 7 des Dickschichtsubstrates 1 sind, wie in Fig. 8, Chipschichtkondensatoren 71 angeklebt und später angelötet. Die konkreten Bauelemente 77' und 79' haben nach Art der MELF-Technik abgewandelte Anschlüsse 85. Diese Anschlüsse 85 sind so gestaucht, daß sie nicht durch die Lotbrückendurchbrüche 83 hindurchschiebbar sind, sondern auf der nicht-getauchten Seite 9 des Dickschichtsubstrates 1 liegen bleiben. Beim Tauchen werden auch hier Lotbrücken 87 von unten nach oben durch das Dickschichtsubstrat 1 aufsteigen und auf der nicht-getauchten Seite 9 mit den gestauchten MELF-Anschlüssen verlötet. Wichtig ist dabei selbstverständlich, daß das Dickschichtsubstrat 1 so tief getaucht wird, daß genügend Lot an der nicht-getauchten Seite 9 aus den Lötdurchbrüchen 83 austreten kann, um mit den gestauchten Anschlüssen 85 zu verlöten.

Beim Tauchen des Dickschichtsubstrates 1 ergibt sich auch noch ein weiterer Vorteil bezüglich des Leitungswiderstandes der gesinterten flächenhaften Leitungszüge. Auch diese gesinterten flächenhaften Leitungszüge werden auf der Tauchseite 7 mit Lot überzogen. Dadurch wird der Leitungswidestand dieser flächenhaften Leitungszüge geringer.

Es muß bei dem Löten selbstveständlich dafür gesorgt werden, daß die abdeckende Lackschicht 75 auf der nicht-getauchten Seite 9 die Lötflächen 17 für die Rahmen 3 und 5 nicht abdeckt, ebenso wie die Kontaktlötflächen für die konkreten Bauteile 77' und 79' mit ihren Anschlüssen in MELF-Technik zum Verlöten freiliegen müssen.

**Patentansprüche**

1. Metallisches, aus aufgefaltetem Blech gebildetes Abschirmgehäuse zur allseitig abgeschirmten Aufnahme einer beschalteten Schaltungsplatine, bei dem der Boden und die Seitenwände durch das Auffalten eines einzigen Blechzuschnittes gebildet sind, dadurch gekennzeichnet, daß auch der Deckel (33) Bestandteil des Blechzuschnittes ist und mit einer Seitenwand (31) durchgehend metallisch durchverbunden bleibt, jedoch längs einer von Knickdurchbrüchen (47) gebildeten Knicklinie (45) schwenkbar an der Seitenwand (31) gehalten ist, wobei die Ränder der Knickdurchbrüche (47) von einer Stanzkante (43) längs der Knicklinie (45) und einer die Enden (49) der Stanzkanten (43) verbindenden, wenigstens im Bereich der Enden (49) gekrümmten Bogenkante (48) gebildet sind.

2. Abschirmgehäuse nach Anspruch 1, dadurch gekennzeichnet, daß in seinen Gehäusewänden (31) Lötdurchbrüche (39) vorgesehen sind, hinter denen flächig die Schaltungsplatine (1) einrahmende Schottwände (11, 13) zu liegen kommen, und daß diese Schottwände (11, 13) mit den Gehäusewänden (31) im Bereich der Lötdurchbrüche (39) verlötet sind.

3. Abschirmgehäuse nach den Ansprüchen 1 und 2, dadurch gekennzeichnet, daß der Antenneneingang durch die Seitenwand geführt ist, längs der sich der homogene Übergang vom Deckel zum Boden vollzieht.

4. Abschirmgehäuse nach Anspruch 1, dadurch gekennzeichnet, daß an wenigstens einer der Gehäusewände (31) Fußlappen (51) vorgesehen sind, auf denen die Vorrichtung hochkant stehend sicher abgestützt ist.

5. Abschirmgehäuse nach Anspruch 1, dadurch gekennzeichnet, daß aus dem Deckel (33) als Füße dienende Stützlappen (61) ausbiegbar sind.

6. Abschirmgehäuse nach Anspruch 1, dadurch gekennzeichnet, daß in dem Boden (29) Fenster (35) vorgesehen sind, durch die die Seite der Platine (1) mit den abgleichbaren Bauteilen zugänglich bleibt, und daß die Fenster (35) mittels einer metallischen Abschirmfolie (67) abdeckbar sind, die gleichzeitig als Typenschild ausgebildet ist.

7. Abschirmgehäuse nach Anspruch 6, dadurch gekennzeichnet, daß die metallische Abdeckfolie (67) selbstklebend ausgebildet ist.

**Claims**

1. A metallic shielded housing formed from folded sheet metal and adapted to receive a printed circuit board so as to be shielded on all sides, in which the bottom and the side walls are formed by folding a single metal sheet cut to size, characterized in that the cover (33) also forms part of the metal sheet cut to size and remains continuously metallically connected to a side wall (31), but is pivotably held along a kink line (45) constituted by kink perforations (47) at the side wall (31), the edges of the kink perforations (47) being constituted by a stamping edge (43) along the kink line (45) and by an arcuate edge (48) interconnecting the ends (49) of the stamping edges (43) and curved at least at the area of the ends (49).

2. A shielded housing as claimed in Claim 1, characterized in that its housing walls (31) are provided with soldering perforations (39), behind which mounting frames (11, 13) enclosing the circuitboard (1) are located in one plane, and in that these mounting frames (11, 13) are soldered to the housing walls (31) at the area of the soldering perforations (39).

3. A shielded housing as claimed in Claims 1 and 2, characterized in that the antenna input is passed through the side wall, along which the homogeneous transition form the cover to the bottom takes place.

4. A shielded housing as claimed in Claim 1, characterized in that at least one of the housing walls (31) provided with foot lobes (51), on which the arrangement is safely supported edgewise.

5. A shielded housing as claimed in Claim 1, characterized in that supporting lobes (61) serving as feet can be bent from the cover (33).

6. A shielded housing as claimed in Claim 1, characterized in that the bottom (29) is provided with windows (35), through which the side of the circuit board (1) provided with the adjustable elements remains accessible, and in that the window (35) can be covered by a metallic shield foil (67), which at the same time serves as a type indication label.

7. A shielded housing as claimed in Claim 6, characterized in that the metallic covering foil (67) is adhesive.

## Revendications

1. Boîtier de blindage métallique en tôle pliée destiné à recevoir une plaquette de circuit câblé avec un effet de blindage de tous côtés et dont le fond et les parois latérales sont formés par le pliage d'un seul flan en tôle, caractérisé en ce que le couvercle (33) fait aussi partie du flan en tôle et reste relié métalliquement sans interruption à une paroi latérale (31), mais est articulé à la paroi latérale (31) suivant une ligne de pliage (45) formée par des jours de pliage (47), les bords des jours de pliage (47) étant formés par un bord découpé (43) le long de la ligne de pliage (45) et par un bord courbe (49) reliant les extrémités (49) du bord découpé et courbé au moins dans la zone des extrémités (49).

2. Boîtier de blindage suivant la revendication 1, caractérisé en ce que dans les parois (31) du boîtier sont prévus des jours de soudage (39) derrière lesquels des cloisons (11, 13) entourant la plaquette de circuit (1) viennent s'appliquer à plat et que ces cloisons (11, 13) sont soudées aux parois (31) du boîtier dans la zone des jours de soudage (39).

3. Boîtier de blindage suivant les revendications 1 et 2, caractérisé en ce que l'entrée d'antenne passe à travers la paroi latérale le long de laquelle la transition homogène du couvercle au fond est réalisée.

4. Boîtier de blindage suivant la revendication 1, caractérisé en ce que sur au moins une des parois (31) du boîtier sont prévues des pattes de base (51) sur lesquelles le dispositif peut prendre solidement appui sur chant.

5. Boîtier de blindage suivant la revendication 1, caractérisé en ce que des pattes de support (61) servant de pieds peuvent être pliées à partir du couvercle (33).

6. Boîtier de blindage suivant la revendication 1, caractérisé en ce que dans le fond (29) sont ménagées des fenêtres (35) par lesquelles la face de la plaquette (1) avec les composants réglables reste accessible, et que les fenêtres (35) peuvent être masquées au moyen d'une pellicule de blindage métallique (67) qui a simultanément la forme d'une plaque signalétique.

7. Boîtier de blindage suivant la revendication 6, caractérisé en ce que la pellicule de recouvrement métallique (67) est une pellicule autocollante.

FIG.1

FIG.2

FIG.3

FIG.4

FIG.5

FIG.5A

FIG.6

FIG.7

FIG.8

FIG.9

F I G.10